# FASCICULE DE BREVET EUROPEEN

(11) **EP 3 552 254 B1**
(45) Date de publication et mention de la délivrance du brevet: **03.06.2020**
(21) Numéro de dépôt: 17805212.2
(22) Date de dépôt: 30.11.2017
(51) Int. Cl.: H01L 51/44, H01L 51/52

(54) **PROCÉDÉ DE FORMATION D'UN EMPILEMENT ET EMPILEMENT**
VERFAHREN ZUR BILDUNG EINES STAPELS UND STAPEL
METHOD FOR FORMING A STACK AND STACK

(30) Priorité: 12.12.2016 FR 1662292
(43) Date de publication de la demande: 16.10.2019
(73) Titulaire: Commissariat à l'Énergie Atomique et aux Énergies Alternatives, 75015 Paris (FR); Trixell, 38430 Moirans (FR)
(72) Inventeur: VERILHAC, Jean-Marie, 38500 Coublevie (FR); BENWADIH, Mohammed, 94500 Champigny sur Marne (FR); CHARLOT, Simon, 38100 Grenoble (FR)
(74) Mandataire: Derval, Estelle
(86) Numéro de dépôt international: PCT/EP2017/080905
(87) Numéro de publication internationale: WO 2018/108540

(56) Documents cités:
- WO-A1-2013/098951
- FR-A1- 3 010 232
- US-A1- 2008 233 826
- US-A1- 2012 126 277
- US-A1- 2013 105 821
- US-A1- 2016 254 498

## Description

L'invention concerne une méthode de réparation des défauts dans les empilements de couches minces destinés à être utilisés dans des dispositifs électroniques.

Les dispositifs en question peuvent, par exemple, être des transistors, par exemple à effet de champ, des diodes redresseuses de courant, des cellules solaires, des cellules photodétectrices, des capacités, des diodes laser, des dispositifs types capteurs, des mémoires, ou encore des diodes électroluminescentes, des composants passifs (inductances, capacitances, résistances), des capteurs de pression ou des capteurs de température. Il s'agit notamment de dispositifs de l'électronique organique sur substrat rigide ou souple (plastique). Ces dispositifs peuvent se présenter sous la forme de composants indépendants ou connectés entre eux. L'empilement peut être destiné à former un unique dispositif ou une pluralité de dispositifs, par exemple une matrice de dispositifs.

L'invention s'applique plus particulièrement au domaine des empilements de diodes organiques utilisés dans les cellules solaires organiques ou les photodétecteurs organiques.

Ces empilements comprennent classiquement une couche mince d'intérêt, organique, partiellement organique ou inorganique, et isolante, semi-conductrice ou conductrice, interposée entre deux couches aptes à conduire de l'électricité.

Dans les dispositifs connus de l'état de la technique, on voit apparaître plusieurs types de défauts topologiques de fabrication des couches d'intérêt. Ces défauts sont du type volume libre. Ils peuvent être du type trous traversant la couche d'intérêt, ils alors débouchent de part et d'autre de la couche active. Il peut également s'agir de zones de volume libre plus important entre la couche active et une couche conductrice que sur le reste de la couche d'intérêt. Ces dernières zones sont par exemple des trous borgnes débouchant en regard d'une seule des couches conductrices. Il peut en variante s'agir de zones dans lesquelles la couche active présente une épaisseur inférieure à une épaisseur nominale prédéterminée selon une direction selon laquelle est réalisé l'empilement.

Ces zones de volume libre plus importants peuvent provenir de particules sur la surface au moment du dépôt de la couche mince, la présence de défauts présents sur le substrat, tels que des pics ou défauts topologiques de la surface ou des zones présentant des tensions de surface différentes, la présence de particules en solution (matériau non dissout) lorsque la couche active est déposée par voie liquide, ou des démouillages locaux de la couche active sur la surface de dépôt, etc... Ces trous peuvent avoir une dimension latérale de 1 nanomètre à plusieurs centaines de micromètres. Ils sont générés lors de la formation de la couche mince.

Ces zones de défauts sont générées lors de la fabrication du dispositif. Les zones de volume libre plus important peuvent générer des fuites électriques (zones où le courant va circuler plus facilement entre les deux électrodes). Des courants de fuite parasites peuvent apparaître dans des dispositifs électroniques dans lesquels la couche mince d'intérêt est censée isoler électriquement les conducteurs formant des électrodes conductrices, dans le cas notamment des diodes organiques. Ainsi, la présence de trous traversants dans la couche active peut conduire à court-circuiter localement les deux électrodes conductrices.

Les courants de fuite parasites sont très pénalisants lorsqu'ils surviennent dans des photodétecteurs organiques ou des diodes redresseuses de courant. En effet, dans ce cas, le courant en régime inverse de la diode et dans le noir doit être très faible (de l'ordre du nA/cm2). Ainsi, la moindre fuite électrique à travers les défauts de la couche d'intérêt peut faire augmenter ce courant de plusieurs décades et dégrader les performances de la diode de manière drastique et irréversible.

Ces courants de fuite parasites sont également pénalisants pour les cellules solaires organiques, mais dans une moindre mesure. Pour un tel dispositif, plus le courant de fuite de la diode est faible et plus la cellule solaire pourra répondre à une faible illumination

Les trous borgnes ou zones de volume libre plus important sont également propices au claquage électrique. Ces zones sont plus fragiles au sens où elles peuvent se dégrader plus facilement sous champ électrique. Or, si dans une photodiode, la couche organique séparant les deux électrodes (couche de photoconversion) présente au moins un défaut de type sous-épaisseur, le champ électrique augmente dans la zone de sous-épaisseur et la rend plus propice à voir apparaître un claquage électrique. Si ce claquage électrique a lieu, il s'en suit une augmentation du courant électrique lu à travers la couche de photoconversion, et ainsi une dégradation des performances de la photodiode.

Ainsi, il a déjà été proposé des solutions pour limiter les courants de fuite parasites dans la couche active d'un empilement et pour limiter les risques de claquage électrique. Un premier type de solution a été proposé dans le but de limiter le nombre de défauts dans les couches actives. Il a notamment été proposé d'augmenter l'épaisseur de la couche active, de filtrer les solutions avant leur dépôt pour former la couche active, d'utiliser des substrats présentant peu de défauts, de nettoyer la surface des substrats avant dépôt de la couche active ou de limiter le nombre de particules dans l'air ambiant en travaillant en salle blanche.

Cependant, les solutions proposées présentent chacune des inconvénients. En effet, une trop forte augmentation de l'épaisseur de la couche active tend par exemple à dégrader les performances des dispositifs. C'est pourquoi l'épaisseur de la couche active est généralement de l'ordre de 1nm à quelques centaines de nanomètres. Par ailleurs, une filtration nécessite une solution présentant une bonne solubilité ce qui n'est pas le cas de tous les matériaux actuellement disponibles pour les couches actives. De plus, l'étape de filtration est difficile à mettre en œuvre au niveau industriel. Les substrats présentant peu de défauts sont des substrats avec des couches présentant un bon caractère nivelant qui sont d'un coût élevé. Le nettoyage des substrats peut quand même laisser certaines tailles de particules. Le travail en salle blanche présente un coût élevé.

Il a également été proposé d'utiliser des doubles couches actives. Toutefois, le concept de double couche, notamment mis en œuvre par voie liquide, nécessite d'utiliser des techniques complexes avec utilisation de solvants sélectifs ou de réticulation des couches afin de ne pas dissoudre la première couche active lors du dépôt de la deuxième couche active.

Un deuxième type de solution a été proposé dans le but de réparer les défauts de la couche active. Il a notamment été proposé, dans la demande de brevet internationale publiée avec le numéro de publication WO 2013/182970, de graver localement une première couche conductrice sur la quelle est formée la couche active à travers les trous formés dans la couche organique est ainsi éviter le contact entre la première couche conductrice et la deuxième couche conductrice formé sur la couche active. Cette technique présente l'inconvénient de ne pas fonctionner pour tout type de première couche conductrice. En particulier, la technique ne fonctionne pas lorsque le matériau de la première couche conductrice est difficile à graver par voie humide. FR3010232 se rapporte à un procédé de réparation de cellules photovoltaïques comprenant une électrode et une couche active. Ce procédé comprend une étape consistant à réaliser des trous dans la couche active et une étape de remplissage du trou au moyen d'un élément isolant transparent pour former un élément de réparation. Cette étape peut être suivie d'une étape de dépôt d'une couche intermédiaire avant de déposer la deuxième électrode.

Il a également été proposé, dans la demande de brevet américain US 2012/0126277 de former une première couche conductrice, de former une couche active sur la première couche conductrice puis de former une couche isolante sur la couche active de sorte que la couche isolante pénètre dans un volume libre de type trou traversant de la couche active. Les parties de la couche isolante extérieures au trou sont ensuite retirées afin de faire apparaître une surface libre de la couche active tout en laissant de la couche isolante à l'intérieur du trou. Une deuxième couche apte à conduire l'électricité est ensuite formée sur la couche active et la couche isolante. Ce procédé permet de limiter les courants de fuite électriques parasites à travers la couche active d'un empilement du type conducteur/couche active/conducteur, et d'éviter la dégradation des performances du dispositif réalisé au moyen de l'empilement. En revanche, cette méthode présente plusieurs inconvénients. Le choix du matériau formant la couche isolante est limité. En effet, ce dernier doit pouvoir combler le trou, être formé sur la couche active et être retiré de la couche active pour faire apparaître la surface libre sans attaquer couche active.

Un but de l'invention est de limiter au moins un des inconvénients précités.

A cet effet, l'invention a pour objet un procédé de réalisation d'un empilement, comprenant les étapes suivantes :
- former une première couche apte à conduire l'électricité,
- former une couche d'intérêt sur la première couche, ladite couche d'intérêt comprenant au moins un volume libre,
- former au moins un élément de réparation, chaque élément de réparation remplissant au moins partiellement un volume libre, appelé volume libre d'intérêt, l'élément de réparation comprenant au moins une couche isolante et laissant libre une surface supérieure de la couche d'intérêt opposée à la première couche et située en dehors dudit au moins un volume libre,
- former une deuxième couche, apte à conduire l'électricité, sur la couche d'intérêt, la deuxième couche recouvrant l'élément de réparation et la surface libre,
l'étape de formation de l'élément de réparation comprenant les étapes suivantes :
- former, sur la couche d'intérêt, une couche tampon s'étendant au moins partiellement dans le volume libre d'intérêt,
- recouvrir au moins une partie de la couche tampon située dans le volume d'intérêt d'une couche de remplissage, ladite couche tampon et la couche de remplissage étant réalisées dans des matériaux différents.

Avantageusement, la couche de remplissage pénètre dans au moins un volume libre d'intérêt.

Avantageusement, la couche tampon empêche tout contact physique entre la couche d'intérêt et la couche de remplissage.

Avantageusement, le procédé comprend une étape d'élimination d'un excès de la couche tampon et d'un excès de la couche de remplissage de sorte à faire apparaître la surface libre de la couche d'intérêt et de sorte à laisser un reste de la couche tampon dans le volume libre d'intérêt.

Avantageusement, la couche de remplissage pénètre dans au moins un volume libre d'intérêt, l'étape d'élimination est réalisée de sorte à laisser un reste de la couche de remplissage dans ledit volume libre d'intérêt, ledit reste recouvrant au moins partiellement le reste de la couche tampon.

Avantageusement, la couche tampon est une couche en matériau isolant.

En variante, l'étape de formation de la couche tampon comprend une étape de dépôt d'une couche en matériau conducteur et une première étape d'oxydation de la couche en matériau conducteur.

Avantageusement, l'étape d'élimination des excès de la couche tampon et de la couche de remplissage est suivie d'une deuxième étape d'oxydation d'une surface libre du reste de la couche tampon.

Selon un mode de réalisation, la couche de remplissage est isolante. En variante, la couche de remplissage est apte à conduire l'électricité.

Avantageusement, la somme de l'épaisseur la couche tampon et de l'épaisseur de la couche de remplissage hors volume libre, selon une direction d'empilement de l'empilement, est supérieure ou égale à l'épaisseur nominale e de la couche d'intérêt hors volume libre.

Avantageusement, la couche tampon est un oxyde métallique isolant.

Avantageusement, la couche de remplissage est une résine de type SU-8 ou est en parylène.

La couche tampon peut être déposée sous vide, avantageusement par dépôt par couche atomique.

La couche de remplissage peut être déposée par voie liquide.

Avantageusement, l'étape d'élimination comprend les étapes suivantes :
- éliminer l'excès de la couche de remplissage de sorte à faire apparaître une surface libre de la couche de réparation,
- éliminer l'excès de la couche tampon de sorte à faire apparaître la surface libre de la couche active.

Avantageusement, l'étape d'élimination de l'excès de la couche tampon comprend une étape d'élimination sélective permettant d'éliminer la couche tampon sans attaquer la couche d'intérêt.

Avantageusement, l'étape d'élimination de l'excès de la couche de remplissage comprend une étape d'élimination sélective permettant d'éliminer la couche de remplissage sans éliminer la couche tampon.

L'invention se rapporte également à un empilement comprenant successivement :
- une première couche apte à conduire l'électricité,
- une couche d'intérêt comprenant au moins un volume libre,
- un élément de réparation remplissant au moins partiellement un volume libre, appelé volume libre d'intérêt, comprenant au moins une couche en matériau isolant et laissant libre une supérieure surface de la couche d'intérêt et située en dehors dudit au moins un volume libre,
- une deuxième couche apte à conduire l'électricité recouvrant l'élément de réparation et la surface supérieure,
l'élément de réparation comprenant une couche tampon et une couche de remplissage recouvrant au moins partiellement une partie de la couche tampon située dans le volume d'intérêt, la couche tampon et la couche de remplissage étant réalisées dans des matériaux différents.

D'autres caractéristiques et avantages de l'invention apparaîtront à la lecture de la description détaillée qui suit, faite à titre d'exemple non limitatif et en référence aux dessins annexés dans lesquels :
- les figures 1a à 1d représentent les produits obtenus lors des étapes successives de réalisation d'un empilement selon l'invention, les flèches représentent les étapes réalisées pour obtenir ces différents produits,
- les figures 2a à 2d représentent les produits obtenus lors des étapes successives permettant de former l'élément de réparation.

D'une figure à l'autre, les mêmes éléments sont repérés par les mêmes références.

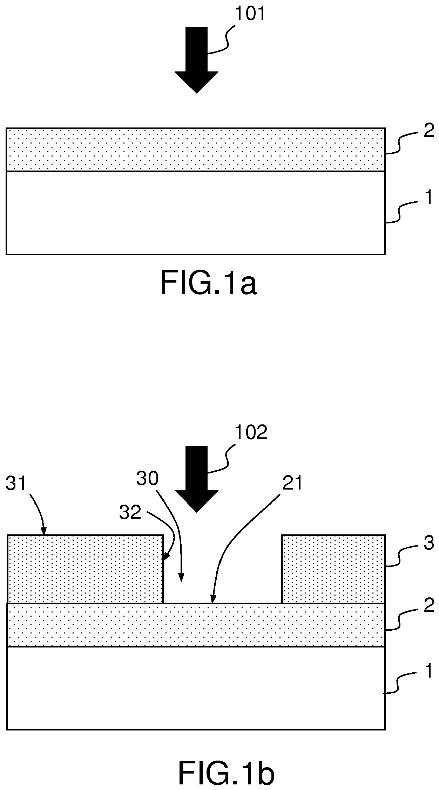

Les figures 1a à 1d illustrent les différentes étapes d'un procédé de réalisation d'un empilement de couches 100 ainsi que les différents produits obtenus à l'issu de ces étapes. Les différentes couches de l'empilement 100 sont empilées selon une direction d'empilement z.

Dans la présente demande, par conducteur, on entend conducteur d'électricité et par isolant on entend isolant électrique.

La première étape 101 du procédé selon l'invention est une étape de formation d'une première couche 2 sur un substrat 1. L'étape 101 consiste par exemple à déposer la première couche 2 sur le substrat.

La première couche 2 est apte à conduire l'électricité. Elle peut être réalisée en matériau conducteur ou semi-conducteur. Elle peut former une électrode, par exemple dans le cas des photodétecteurs organiques et des cellules solaires organiques du type première électrode/ couche active/deuxième électrode.

Le substrat 1 peut être de nature quelconque. Il s'agit par exemple d'un substrat rigide en verre ou d'un substrat souple, par exemple, en matière plastique par exemple du PET ou PEN.

La deuxième étape 102 consiste à former une couche active 3, visible sur la figure 1b, sur la première couche 2. La couche active 3 est avantageusement déposée sous la forme d'une couche mince. Elle présente une épaisseur par exemple comprise entre 1nm et plusieurs micromètres.

La couche active 3 peut comprendre au moins un matériau qui est de nature organique comme par exemple un polymère, un oligomère, un dendrimère ou une petite molécule organique. Elle peut comprendre au moins un matériau de nature inorganique, comme par exemple, un oxyde de silicium, un nitrure de silicium, de l'alumine, ou une boîte quantique (« quantum dot » en terminologie anglo-saxonne). Elle peut aussi comprendre au moins un matériau de la famille des pérovskites.

Dans le cas des photodétecteurs organiques et des cellules solaires organiques, la couche active 3 peut être une couche de photoconversion.

La couche active 3 comprend avantageusement un mélange d'un matériau donneur d'électrons et d'un matériau accepteur d'électrons. Le matériau semi-conducteur donneur peut être une molécule, un oligomère ou un polymère organique π conjugué, c'est-à-dire avec une alternance de liaisons simples et de liaisons double. Le mélange classiquement utilisé est le couple poly(3-hexylthiophène) régiorégulier (P3HT RR) et le [6,6]-Phényl C61 butyric acid methyl ester ([60]PCBM). D'autres polymères donneurs à fort gap (PFB, TFB, PTAA, PCDTBT, etc...) ou à faible gap (PDPP3T, PCPDTBT, Si-PCPDTBT, PDDTT, etc...) pourront avantageusement être utilisés. De même, pour le matériau accepteur, d'autres matériaux peuvent avantageusement être utilisés, du type dérivés du C60, C70 ou C80 (PCBM, indène-C60, indene-C60 bis adduct), nanotubes de carbone, molécules de type acène diimide, ou polymère (F8BT, N2200). Le matériau accepteur peut également être de nature inorganique, comme des nanoparticules de TiO₂ ou de ZnO.

Ainsi, la couche active 3 peut être une hétérojonction d'un matériau donneur d'électrons et d'un matériau accepteur d'électrons se présentant sous la forme d'un empilement de plusieurs couches actives élémentaires. La couche active peut également se présenter sous la forme d'une unique couche comprenant une hétérojonction volumique. Elle comprend alors un mélange de deux matériaux sous la forme d'hétérojonction en volume, c'est-à-dire d'un mélange intime des deux matériaux à l'échelle nanométrique.

Sur la réalisation des figures, la couche active 3 se présente sous la forme d'une seule couche, c'est-à-dire d'une seule couche active élémentaire. Cette couche active 3 est en contact avec la première couche 2.

Les matériaux constitutifs de la couche active 3 peuvent être déposés sous la forme de solutions. Ces solutions peuvent être filtrées de façon à limiter la présence d'agrégats. Ceci permet également de limiter la création de défauts dans la couche active.

De façon optionnelle, une couche d'interface peut être déposée sur la première couche 2 avant la couche active 3. Autrement dit, la couche d'interface est interposée entre la première couche 2 et la couche d'intérêt 3. Cette couche n'est pas représentée sur la figure 1b. Cette couche d'interface peut par exemple être réalisée en PEDOT : PSS, graphène, dérivé de polyfluorene, tetrakis (dimethylamino)éthylène (TDAE), poly(oxyde d'éthylène), polyethylenimine ethoxylé (PEIE), polyethylenimine branché (PEI), WO₃, MoO₃, LiF, NiO, V₂O₅, TiOₓ, ZnO ou CsCO₃ ou encore par l'utilisation d'une couche auto-assemblée (SAM) à la surface de l'électrode conductrice.

Cette couche d'interface permet d'ajuster le travail de sortie de la première couche 2 et la couche active 3. Par exemple si l'ITO a un travail de sortie de 4.6eV, l'utilisation d'une fine couche de ZnO à sa surface permet d'ajuster le travail de sortie de surface (à l'interface électrode/couche active) à 4.3eV sans trop modifier la conductivité de l'électrode conductrice perpendiculairement au substrat.

Comme indiqué précédemment, la couche d'intérêt 3 comporte au moins une zone de volume libre 30. Ce volume libre 30 consiste en un trou traversant sur l'exemple non limitatif de la figure 1b. Le volume libre est situé au droit de la première couche 2.

De manière générale, les volumes libres ou défauts peuvent consister en des trous micrométriques ou en des zones présentant une épaisseur moins importante qu'une épaisseur e souhaitée prédéterminée de la couche active selon la direction d'empilement z. Il peut s'agir de porosités ou encore de volumes qui ne sont pas occupés par les chaines polymères. Ils présentent des dimensions comprises entre 1 nm et plusieurs millimètres.

Les volumes libres sont des défauts de la couche d'intérêt. Ces défauts sont préexistants. Autrement dit, ces volumes libres ou défauts sont formés lors de la formation de la couche d'intérêt.

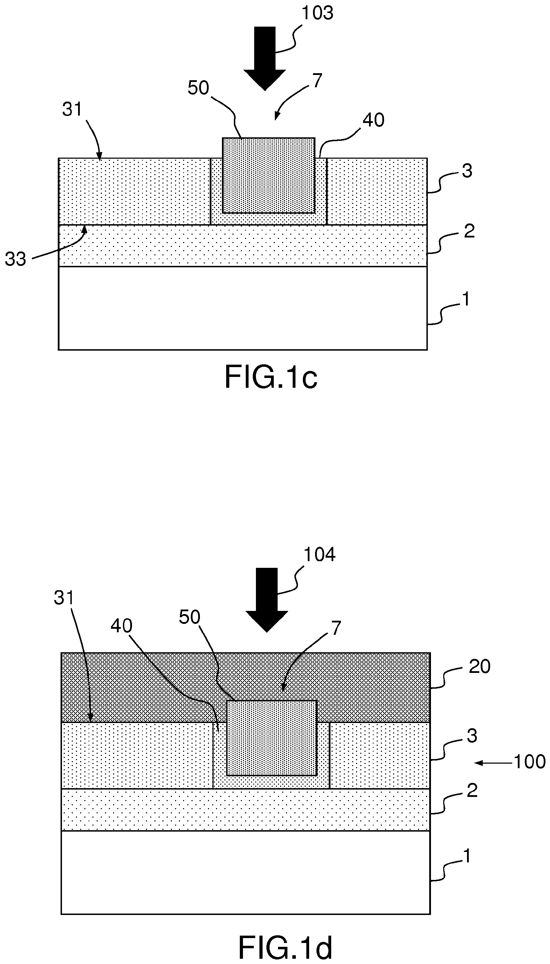

Le procédé selon l'invention comprend une étape 103 de réparation consistant à former un élément de réparation 7, visible sur la figure 1c. L'élément de réparation 7 remplit au moins partiellement et de préférence totalement au moins un volume libre 30, appelé volume d'intérêt.

L'élément de réparation 7 laisse libre une surface 31 de la couche active 3 qui est une partie de la surface supérieure de la couche active 3, c'est-à-dire de la surface de la couche active 3 qui est opposée à la surface 33 de la couche active située en regard de la première couche 2. La surface 31 est située en dehors de tout volume libre 30.

L'élément de réparation 7 comprend au moins une couche isolante électriquement.

Le procédé de réalisation de l'empilement 100 comprend en outre une étape 104 de formation d'une deuxième couche 20, visible sur la figure 1d, apte à conduire de l'électricité sur l'élément de réparation et la couche d'intérêt 3. Il peut s'agir d'une couche en matériau conducteur d'électricité ou en matériau semi-conducteur. Elle peut former une électrode conductrice, par exemple dans le cas des photodétecteurs organiques et des cellules solaires organiques du type première électrode/ couche active/deuxième électrode.

Avantageusement, la deuxième couche 20 recouvre l'élément de réparation 7 et la surface libre 31. Elle est avantageusement continue. La deuxième couche 20 est en contact avec l'élément de réparation 7 et avec la surface libre 31.

L'élément de réparation 7 comprenant au moins une couche isolante, remplissant au moins partiellement l'intérieur du volume libre 30 et étant interposé entre les deux couches 2 et 20, permet de limiter les risques de contact physique et électrique entre les deux couches 2 et 20 et ainsi de limiter les courts-circuits et les courants de fuite au travers du volume libre 30.

Avantageusement, l'élément de réparation 7 est configuré et agencé de façon à interdire tout contact physique et électrique entre la première couche 2 et la deuxième couche 20 au travers du volume libre d'intérêt 30. Il comprend au moins une couche isolante assurant cette séparation physique et électrique. L'élément de réparation 7 permet de limiter au maximum l'augmentation des courants de fuite au travers des volumes libres et de limiter les risques de claquage électrique lorsque les volumes libres sont du type trou non traversant.

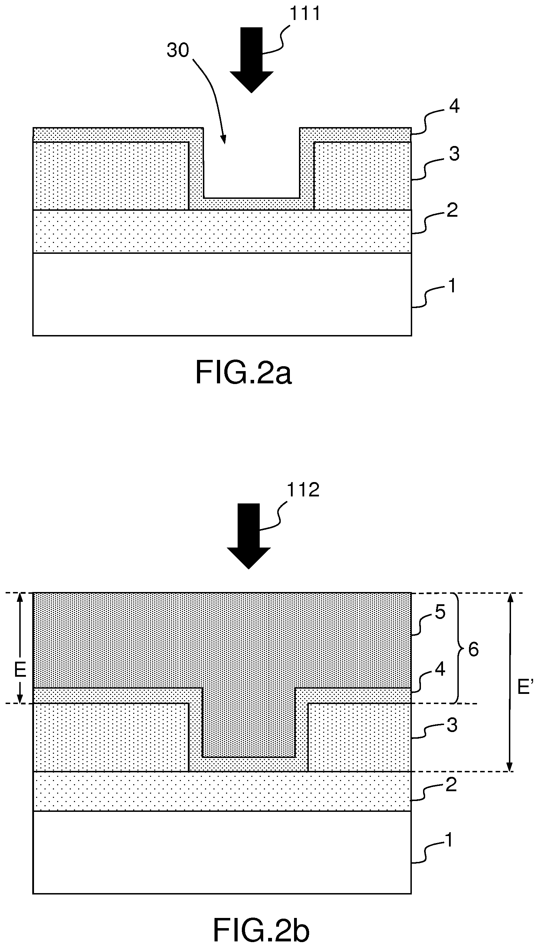

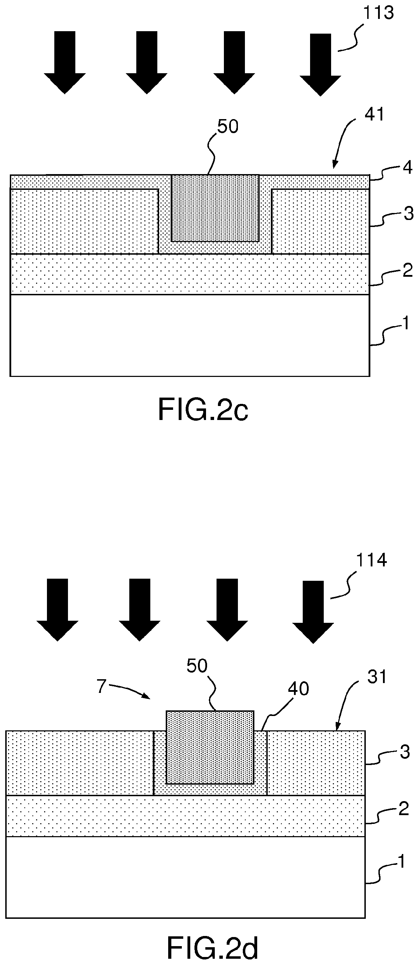

L'élément de réparation 7 peut présenter, selon l'axe z, une épaisseur supérieure égale à la profondeur du volume libre selon l'axe z comme représenté sur la figure 2d ou bien affleurer la surface libre 31 ou bien présenter une épaisseur inférieure à la profondeur du volume libre selon l'axe z. Il peut également présenter une épaisseur constante selon l'axe z ou non constante comme cela est représenté sur la figure 2d.

Nous allons maintenant décrire plus précisément le procédé de formation de l'élément de réparation puis sa structure.

Selon l'invention, l'étape de formation 104 de l'élément de réparation 7 comprend les étapes suivantes représentées sur les figures 2a à 2b :
- former 111 une couche tampon 4 sur la couche active 3 de sorte que la couche tampon 4 s'étende au moins partiellement dans le volume libre d'intérêt 30,
- former 112 une couche dite de remplissage 5 recouvrant au moins une partie de la couche tampon 4 située dans le volume d'intérêt 30. Sur la réalisation de la figure, la couche de remplissage recouvre totalement la couche tampon 4.

Par ailleurs, la couche tampon 4 et la couche de remplissage 5 sont réalisées dans des matériaux différents.

L'utilisation de matériaux différents implique un choix plus vaste de matériaux pour former les couches 4 et 5 ainsi qu'un choix plus large de leurs procédés de formation respectifs.

Le procédé selon l'invention permet de conserver au moins partiellement l'intégrité de la couche active 3 et/ou de la première couche 2 et d'assurer un bon remplissage du volume libre 30. Il est notamment possible de choisir une couche de remplissage 5 assurant un bon remplissage du volume libre mais dont un procédé de dépôt et/ou un procédé d'élimination, comme nous le décriront plus précisément par la suite, pourraient détériorer la couche active 3, puisque cette dernière est protégée par la couche tampon 4 des étapes de dépôt et/ou de traitement de la couche de remplissage 5. On peut ainsi choisir une couche 4 pouvant être déposée et/ou éliminée sans détériorer la couche active 3 mais qui en contrepartie n'a pas nécessairement de bonnes propriétés pour remplir les volumes libres.

Avantageusement, la couche tampon 4 est interposée entre la couche de remplissage 5 et la couche active 3.

Avantageusement, les étapes 111 et 112 sont réalisées de façon que la couche tampon 4 empêche tout contact physique entre la couche de remplissage 5 et la couche active 3. La protection de la totalité de la couche active 3 est alors assurée. Ainsi, la couche tampon 4 couvre avantageusement la totalité de la surface 32 délimitant le volume libre 30. Cela permet d'assurer un remplissage maximal du volume 30 au moyen de la couche de réparation 5 tout en assurant la protection maximale de la couche active 3.

La couche de remplissage 5, formée ou déposée sur la couche tampon 4, pénètre en réalité dans les volumes libres 30 de taille suffisante, c'est-à-dire les volumes libres 30 qui ne sont pas complètement remplis au moyen de la couche tampon 4. Les volumes de taille plus petite sont comblés totalement par la couche tampon 4 pour une épaisseur donnée de couche tampon déposée sur la couche active 3. Elle permet d'assurer un bon remplissage de ces grands volumes libres même si la couche tampon 4 ne peut pas être déposée sous forme d'une couche suffisamment épaisse pour combler le volume. Avantageusement, la formation de la couche de remplissage 5 est réalisée de façon qu'elle remplisse au moins partiellement un volume libre d'intérêt parmi les volumes libres d'intérêt.

Dans le procédé représenté sur les figures 2a à 2b, les couches 4 et 5 s'étendent dans le volume libre 30 et sur la surface 31. Plus généralement, les couches 4 et 5 peuvent s'étendre sur une surface libre supérieure de la couche active 3 située en dehors de tout volume libre 30.

L'étape de formation de l'élément de réparation 7 comprend avantageusement une étape d'élimination 113, 114 représentée sur les figures 2c et 2d. Dans cette étape, on élimine un excès de chacune des couches 4, 5 de sorte à faire apparaître la surface libre 31 visible sur la figure 2d de la couche active 3 et de sorte à conserver un reste 40 de la couche tampon 4, ledit reste 40 pénétrant au moins partiellement dans le volume libre 30. Ce procédé est aisé et rapide. Il n'est pas nécessaire de disposer de la précision suffisante pour déposer les couches 4 et 5 uniquement dans et au droit du volume libre 30.

Dans le procédé représenté sur les figures 2c et 2d, l'étape d'élimination est réalisée de sorte à conserver un reste de la couche de réparation 5, ce reste 50 pénètre au moins partiellement dans le volume 30 est recouvre au moins partiellement le reste de la couche tampon 4.

Les couches 4 et 5 sont avantageusement formées sous forme de couches continues. La couche 4 s'étend en partie dans le volume libre 30 et en regard de la surface 31. La couche 5 s'étend en partie en regard du volume libre 30 et en regard de la surface 31. En variante, au moins une de ces couches est formée sous forme d'une couche discontinue.

En variante, les couches 4 et 5 sont déposées localement uniquement dans au moins un des volumes 30. Dans ce cas, le procédé ne comprend pas d'étape d'élimination ou l'étape d'élimination ne comprend pas d'élimination autour des volumes 30. Les couches 4 et 5 sont alors les couches 40 et respectivement 50 formant l'élément de réparation 7. Ce mode de réalisation est moins rapide et plus onéreux que le mode de réalisation préféré décrit précédemment.

Sur la réalisation non limitative de la figure 2d, l'élément de réparation 7 est formé par les restes 40, 50 des couches 4 et 5 à l'issu de l'étape d'élimination 113, 114. Le reste de la couche 4 et le reste de la couche 5 forment respectivement une couche tampon restante 40 et une couche de remplissage restante 50.

Sur la réalisation des figures, la couche tampon 4 est contigüe à la couche active 3.

Sur la réalisation des figures, la couche de remplissage 5 est contigüe à la couche tampon 4.

Avantageusement, la couche 4 est réalisée en un matériau isolant électrique. Elle permet ainsi d'assurer tout ou en partie la fonction d'isolation électrique de l'élément 7. Avantageusement la couche tampon restante 40 empêche tout contact physique entre les couches 2 et 20 aptes à conduire l'électricité et entre la couche 2 et la couche de réparation restante 50. L'élément de réparation 7 permet ainsi d'empêcher tout contact physique entre les couches 2 et 20 sans qu'il ne soit obligatoire d'utiliser une couche de réparation 5 ou 50 isolante électriquement. Le choix des matériaux pour réaliser cette couche 5 ou 50 est ainsi plus vaste. A cet effet, la couche tampon restante 40 recouvre avantageusement, mais non nécessairement la partie 21 de la surface de la première couche 2 sur laquelle débouche le volume libre 30, lorsque le volume libre est du type traversant.

En variante, la couche tampon 4 comprend une couche d'un matériau conducteur susceptible d'être oxydé de sorte à former un oxyde isolant électriquement et une couche dudit oxyde recouvrant la couche de matériau conducteur. L'étape de formation de la couche tampon 4 comprend alors une étape de dépôt ou de formation d'une couche de matériau conducteur et une première étape d'oxydation de cette couche en surface de sorte à former une couche isolante. Ce traitement peut être tout simplement de l'exposer à l'air plusieurs minutes ou de faire un traitement oxydant type plasma oxygène sous haute pression (100mT minimum et une puissance entre 200 et 500W).

Lorsque l'on élimine les excès des couches 4 et 5 en vue de former les couches 40 et 50, la couche d'oxyde est alors supprimée en dehors de l'interface entre les couches 4 et 5. L'étape d'élimination 113, 114 est alors avantageusement suivie d'une deuxième étape d'oxydation pour oxyder la partie restante de la couche tampon 4 en surface de façon à la rendre isolante de sorte à obtenir la couche tampon finale 40. Cela permet d'obtenir une couche 40 isolante et de limiter au maximum les courants de fuite. En variante, le procédé ne comprend pas cette étape d'oxydation.

Avantageusement, la couche de remplissage 5 est en un matériau isolant électrique. Lorsque les deux couches 4 et 5 (ou 40 et 50) sont isolantes, le mode de réalisation est optimal car il permet de maximiser la matière isolante entre les deux couches conductrices 2, 20 c'est-à-dire entre les couches entre lesquelles la couche d'intérêt est prise en sandwich. La distance entre les deux couches conductrices 2, 20 est maximale sur toute la surface latérale (c'est-à-dire la surface dans un plan perpendiculaire à la direction de l'empilement) de l'élément de réparation 7 ce qui permet de limiter au maximum la valeur du champ électrique à l'intérieur du défaut, la valeur de ce champ électrique étant inversement proportionnelle à la distance entre les électrodes.

Dans une variante moins avantageuse, la couche de remplissage 5 ou la couche de remplissage finale 50 est une couche en matériau apte à conduire l'électricité conducteur ou semi-conducteur. Autrement dit, la couche de remplissage 5 est apte à conduire l'électricité

Un matériau isolant formant la couche tampon 4 ou 40 est par exemple pris parmi un des matériaux isolants suivants : un oxyde métallique isolant comme par exemple l'alumine Al₂O₃, Parylène, Polyimide, PMMA, Polystyrène, Polyvinylpyrolidone, Polyvinylphénol, Polyvinyl alcool, Polyallylamine, polymère fluoré de type CYTOP, résine fluorée de chez Orthogonal® et de type OSCoR4001 . L'utilisation d'un oxyde métallique isolant comme par exemple l'alumine est avantageuse car il s'agit d'un bon isolant électrique qui peut être déposé en couches minces (typiquement < 100nm). L'avantage est que l'on peut le déposer par les techniques sous vide, notamment par dépôt par couche atomique ALD, qui permet de déposer des couches très conformes ou très recouvrantes.

Un matériau conducteur formant ces couches 4, 40 est par exemple un métal, par exemple de l'aluminium, du Cr, du Ti.

Avantageusement, la couche tampon 4 ou la couche 40 est formée par dépôt par couche atomique ou comprend une étape de dépôt d'une couche sous vide. Le dépôt par couche atomique est appelé « Atomic Layer Déposition » ou ALD en terminologie anglo-saxonne. Ce procédé de dépôt permet de réaliser des dépôts qui se conforment à la surface délimitant le volume libre ce qui permet de recouvrir toute la surface délimitant le volume libre. Par ailleurs, en procédant à ce dépôt à température suffisamment faible (inférieure ou égale à environ 150°C), cette technique n'endommage pas les couches actives de type organiques. Toutefois, cette technique de dépôt est coûteuse. Elle, ne permet pas de réaliser des dépôts d'épaisseur importante. En effet, les dépôts réalisés présentent typiquement une épaisseur comprise entre 0, 1 nm et 300 nm. Il est possible de faire des dépôts présentant une épaisseur supérieure à 300 nm mais les durées de dépôt deviennent alors extrêmement longues (de l'ordre de plusieurs heures. Les dépôts ainsi réalisés sont conformes à la surface délimitant le volume libre mais présentent un faible effet nivelant. Le dépôt de la couche de remplissage 5 permet donc de venir compléter le remplissage des volumes libres dont la taille est trop importante pour que l'on puisse les combler complètement par ALD.

De manière plus générale, la couche 4 ou la couche 40 est avantageusement formée par dépôt sous vide ou comprend une étape de dépôt d'une couche sous vide. Ce dépôt est par exemple réalisé par une des techniques suivantes : dépôt chimique en phase vapeur CVD (acronyme de l'expression anglo-saxonne « chemical vapor déposition »), dépôt chimique en phase vapeur amélioré par plasma PECVD (acronyme de l'expression anglo-saxonne « plasma enhanced chemical vapor déposition »), ALD, évaporation par effet joule, évaporation par canon à électrons, polymérisation par plasma. Les techniques de dépôt sous vide donnent souvent des dépôts conformes, bien recouvrant qui peuvent permettre de recouvrir la totalité de la surface 32 délimitant un volume libre. De plus, comme la couche active 3 est soluble dans des solvants, les techniques sous vide évitent d'utiliser un solvant susceptible de détériorer la couche active.

La couche de remplissage 5 ou la couche 50 isolante est réalisée dans un matériau par exemple pris parmi un des matériaux isolants listés ci-après : parylène, résine photosensible telle que la résine époxy SU-8 ou SU-18, une autre résine époxy ou polyépoxyde, polystyrène, polyimide, poly(méthacrylate de méthyle) PMMA, polyvinylpyrolidone, polyvinylphénol, polyvinyl alcool ; polyallylamine, polymère fluoré de type CYTOP, résine fluorée de chez Orthogonal® et de type OSCoR4001 ou PEDOT. En variante, la couche de remplissage 5 ou la couche 50 est une couche de matériau conducteur électrique comme par exemple le PEDOT : PSS, ou en polyaniline (PAni). L'utilisation de parylène, par exemple le parylène C, est avantageuse possède de bonnes propriétés de recouvrement de surface. Il va combler les défauts et se déposer sur la surface de la couche active tout en nivelant sa surface. Toutefois, l'élimination de ce type de couche doit être réalisée par gravure au plasma. Or, cette technique est susceptible de graver la couche active. La couche tampon 4 (figure 2a) permet de protéger la couche d'intérêt 3 de ce type de gravure.

L'utilisation de résine SU-8 est également avantageuse car la résine SU8 est un polymère visqueux pouvant être déposé en couches assez épaisses.

La couche de remplissage 5 ou la couche 50 peut être une couche d'un même matériau que la couche d'intérêt 3. Elle est par exemple réalisée en matériau organique.

Elle peut être déposée par voie liquide par un technique telle que l'enduction centrifuge (« spin coating » en terminologie anglo-saxonne), l'enduction par trempage ou « dip-coating », l'enduction par filière en forme de fente ou « slot-die coating », lasérigraphie, l'héliographie, la flexographie, le revêtement par jet d'encre « inkjet coating », le revêtement par pulvérisation ou « spray-coating »...). Ces techniques de dépôt permettent de réaliser des dépôts épais et présentant un plus grand effet nivelant que les dépôts sous vide

Avantageusement, le parylène est déposé sous vide ou vide partiel, par exemple par une technique d'évaporation par effet Joule.

Bien entendu, les couches 4 et 40 peuvent être déposées par voie liquide et les couches 5 et 50 peuvent être déposées sous vide.

Avantageusement, l'épaisseur E de la couche de réparation 6 formée par la couche tampon 4 et la couche de remplissage 5, hors zone de défaut 30 et selon la direction d'empilement z, est supérieure ou égale à l'épaisseur nominale e de la couche d'intérêt 3 et de préférence supérieure ou égale à une fois et demi l'épaisseur nominale de la couche d'intérêt 3 et de préférence égale au double de l'épaisseur nominale de la couche d'intérêt 3. L'épaisseur nominale e de la couche d'intérêt 3 est l'épaisseur de la couche d'intérêt hors volumes libres 30 et selon l'axe z. Cela favorise le nivèlement de la couche de la couche de réparation et permet de faciliter l'élimination de l'excès de la couche de réparation, notamment par gravure tout en laissant une partie de la couche de réparation à l'intérieur du défaut. En effet, l'épaisseur E' de la couche de réparation au niveau de la zone de défaut est supérieure à l'épaisseur E de la couche de réparation autour de la zone de défaut 30.

De manière plus générale, l'épaisseur de la couche de réparation est avantageusement ajustée finement en fonction de la dimension latérale (c'est-à-dire dans un plan perpendiculaire à z) et de la profondeur (selon la direction z) des défauts à passiver.

Nous allons maintenant décrire l'étape d'élimination 113, 114 de l'excès de la couche de réparation 6 de sorte à faire apparaître une surface libre 31 de la couche d'intérêt 3 en dehors du volume libre 3 et de sorte à laisser au moins une partie de la couche de réparation 6 dans le volume libre 30.

Avantageusement, comme représenté sur les figures 2c et 2d, l'étape d'élimination 113, 114 comprend les étapes suivantes :
- éliminer 113 un excès de la couche de remplissage 5 de sorte à faire apparaître une surface libre 41 de la couche tampon 4 en dehors du volume libre 30 et, avantageusement, de sorte à laisser le reste de la couche de remplissage 5,
- éliminer 114 un excès de la couche tampon 4 de sorte à faire apparaître la surface libre 31 de la couche d'intérêt 3 et à laisser le reste de la couche tampon 4.

L'étape de formation de la couche 40 comprend alors les étapes 111 et 113 et l'étape de formation de la couche 50 comprend les étapes 112 et 114.

Avantageusement, comme représenté sur les figures, la surface libre 31 est une partie de la surface de la couche d'intérêt qui en contact avec la couche de réparation 6. En variante, l'étape d'élimination de l'excès de la couche de réparation 6 ou de la couche tampon, élimine une partie de la couche d'intérêt 3 de sorte à faire apparaître la surface libre 31.

Avantageusement, la surface libre 41 est une partie de la surface de la couche tampon qui en contact avec la couche de remplissage 5. En variante, l'étape d'élimination de l'excès de la couche de remplissage 5 élimine une partie de la couche tampon 4 de sorte à faire apparaître la surface libre 41.

Les deux étapes d'élimination 113 et 114 sont avantageusement réalisées au moyen de techniques d'élimination différentes. En variante, cette étape peut être réalisée au moyen d'une même technique d'élimination.

Avantageusement, l'étape d'élimination 113 de l'excès de la couche de remplissage 5 est une étape d'élimination sélective permettant d'éliminer l'excès de couche de remplissage 5 sans éliminer la couche tampon 4. Cette technique d'éviter d'avoir à maîtriser l'arrêt de l'étape d'élimination de l'excès de la couche de remplissage 5 juste au niveau de la partie de la surface de la couche tampon 4 qui est en contact avec la couche de remplissage 5 en dehors des volumes libres 30. Par ailleurs, elle permet d'assurer la protection de la couche d'intérêt 3 du procédé d'élimination de la couche de remplissage 5 au moyen de la couche tampon 4.

Avantageusement, l'étape d'élimination 114 de l'excès de la couche tampon 4 est une étape d'élimination sélective permettant de graver la couche tampon 4 sans éliminer la couche d'intérêt 3. En variante, l'étape d'élimination 114 de l'excès de la couche tampon 4 est une étape d'élimination sélective permettant d'éliminer l'excès de la couche tampon 4 sans affecter ses propriétés électriques et/ou optiques et /ou mécaniques de la couche d'intérêt 3, c'est-à-dire sans attaquer la couche d'intérêt 3. Ces techniques permettent d'éviter d'avoir à maîtriser l'arrêt de l'étape d'élimination de la couche tampon 4 juste au niveau de la surface libre 31 de la couche active 3.

Les étapes d'élimination sont par exemple obtenues par une technique de gravure de préférence en voie humide, c'est-à-dire par mise en contact avec une solution de gravure. Dans certains cas, cette élimination est obtenue avec un solvant. C'est cependant le terme de solution de gravure qui sera généralement utilisé dans la suite de la description.

La solution de gravure utilisée pour l'élimination de l'excès de la couche tampon 4 doit être choisie de façon à ne pas dégrader les propriétés électriques, optiques et mécaniques de la couche d'intérêt 3. Les propriétés électriques de la couche d'intérêt 3 peuvent être dégradées du fait d'une augmentation ou d'une diminution de sa conductivité, ou encore de la génération de pièges électriques intrinsèques ou extrinsèques à la couche active. La dégradation des propriétés optiques de la couche d'intérêt 3 peut par exemple se traduire par une diminution des propriétés d'absorption de la lumière à la longueur d'onde désirée. Enfin, la dégradation des propriétés mécaniques peut se traduire notamment par un décollement, une fissuration ou une perte de flexibilité de la couche active. Ainsi, de façon générale, la solution de gravure utilisée sera sélective, c'est-à-dire qu'elle pourra graver couche tampon 4, sans pour autant graver ou attaquer la couche d'intérêt 3.

De même, avantageusement, lorsque l'excès de la couche de remplissage 5 est éliminé par gravure en voie humide, avantageusement, solution de gravure utilisée sera sélective, c'est-à-dire qu'elle pourra graver couche de remplissage 5, sans pour autant graver ou attaquer la couche tampon 4.

De façon générale, la solution de gravure comprendra un acide, une base ou une solution neutre. Elle pourra être pure ou encore diluée dans l'eau ou dans un solvant orthogonal à la couche active, c'est-à-dire un solvant non susceptible d'attaquer ou de dissoudre la couche active. Un solvant orthogonal à une couche active organique est, par exemple, de façon non limitative, du type méthanol, éthylène glycol, n-butylacetate. Son choix dépend de la nature de la couche active.

La solution de gravure peut être apportée sur toute la surface de la couche active ou de manière localisée.

En variante, au moins une des étapes d'élimination 113, 114 est réalisée par voie sèche, comme par exemple par gravure plasma ou ionique (RIE : gravure ionique profonde, RIE-ICP (torche plasma ou gravure ionique réactive, ...)), ou une combinaison ou alternance des 2. La gravure sèche permet de mieux contrôler l'homogénéité de la gravure sur toute la surface. On peut également finement contrôler la vitesse de gravure et ainsi mieux maitriser la fin de la gravure. En variante, l'élimination est par exemple réalisée par insolation, ablation laser, abrasion ou ponçage.

Dans certains cas, la surface de la couche d'intérêt 3 pourra être activée par un traitement chimique ou physique (par exemple plasma) doux ayant pour but de faciliter la pénétration de la couche de réparation dans les défauts de la couche active.

La présente invention s'applique également au domaine des transistors organiques, comme par exemple les transistors à film mince, plus communément connu sous l'expression anglo-saxonne « Organic Thin Film Transistor » (OTFT). Dans ce type de conducteur, la première couche 2 est une couche en matériau semi-conducteur déposée sur des électrodes de source et de drain et la deuxième couche 20 est une électrode de grille. La couche active ou couche d'intérêt est une couche de diélectrique de grille interposée entre l'électrode de grille et la couche de semi-conducteur formant la première couche 2.

Dans une variante de réalisation, la couche active 3 comprend une pluralité de couches actives élémentaires. L'étape de formation d'au moins un élément de réparation 7 peut alors être appliquée à une des couches actives élémentaire. Le procédé peut comprendre une ou plusieurs étapes de formation d'au moins un élément de réparation remplissant sur une ou plusieurs couches actives élémentaires respectives. Chaque couche 2 ou 20 peut alors par exemple être une couche destinée à former une électrode ou bien une autre couche active élémentaire.

L'invention se rapporte à l'empilement obtenu par le procédé selon l'invention.

L'invention se rapporte également à un empilement comprenant successivement :
- une première couche 2 apte à conduire l'électricité,
- une couche d'intérêt 3 comprenant des volumes libres 30, au moins un des volumes libres, appelé volume libre d'intérêt est rempli au moins partiellement au moyen d'un élément de réparation 7,
- une deuxième couche 20 apte à conduire l'électricité recouvrant l'élément de réparation et une zone de la couche d'intérêt extérieure à tout volume libre 30.

L'élément de réparation 7 comprend au moins une couche tampon restante 40 s'étendant au moins partiellement dans le volume libre 30 et une couche de remplissage restante 50 recouvrant au moins une partie de la couche tampon 4 située dans le volume libre d'intérêt 30. La couche de remplissage restante 50 recouvre au moins partiellement la couche tampon restante 40. Ces couches sont formées dans des matériaux différents.

Ces couches sont avantageusement continues.

La couche tampon restante 40 est avantageusement interposée entre la couche d'intérêt 3 et/ou la première couche 2 et la couche de remplissage restante 50. Avantageusement, la couche tampon restante 40 recouvre complètement la surface délimitant le volume libre 30.

## Revendications

1. Procédé de réalisation d'un empilement (100), comprenant les étapes suivantes :
- former (101) une première couche (2) apte à conduire l'électricité,
- former (102) une couche d'intérêt (3) sur la première couche (2), ladite couche d'intérêt (3) comprenant au moins un volume libre,
- former au moins un élément de réparation (7), chaque élément de réparation remplissant au moins partiellement un volume libre, appelé volume libre d'intérêt, l'élément de réparation (7) comprenant au moins une couche isolante et laissant libre une surface supérieure (31) de la couche d'intérêt (3) opposée à la première couche (2) et située en dehors dudit au moins un volume libre,
- former (104) une deuxième couche (20), apte à conduire l'électricité, sur la couche d'intérêt (3), la deuxième couche (20) recouvrant l'élément de réparation (7) et la surface libre (31),
l'étape de formation de l'élément de réparation (7) comprenant les étapes suivantes :
- former (111), sur la couche d'intérêt (3), une couche tampon (4) s'étendant au moins partiellement dans le volume libre d'intérêt (30),
- recouvrir (112) au moins une partie de la couche tampon (4) située dans le volume d'intérêt (30) d'une couche de remplissage (5), ladite couche tampon (4) et la couche de remplissage (5) étant réalisées dans des matériaux différents.

2. Procédé de réalisation d'un empilement selon la revendication précédente, dans lequel la couche de remplissage (5) pénètre dans au moins un volume libre d'intérêt (30).

3. Procédé de réalisation d'un empilement selon l'une quelconque des revendications précédentes, dans lequel la couche tampon (4) empêche tout contact physique entre la couche d'intérêt (3) et la couche de remplissage (5).

4. Procédé de réalisation d'un empilement selon la revendication précédente, comprenant en outre une étape d'élimination (113, 114) d'un excès de la couche tampon (4) et d'un excès de la couche de remplissage (5) de sorte à faire apparaître la surface libre (31) de la couche d'intérêt (3) et de sorte à laisser un reste de la couche tampon (4) dans le volume libre d'intérêt.

5. Procédé de réalisation d'un empilement selon la revendication précédente, dans lequel la couche de remplissage (5) pénètre dans au moins un volume libre d'intérêt (30), l'étape d'élimination est réalisée de sorte à laisser un reste de la couche de remplissage (5) dans ledit volume libre d'intérêt, ledit reste recouvrant au moins partiellement le reste de la couche tampon (4).

6. Procédé de réalisation d'un empilement (100) selon l'une quelconque des revendications précédentes, dans lequel la couche tampon (4) est une couche en matériau isolant.

7. Procédé de réalisation d'un empilement selon l'une quelconque des revendications 1 à 5, dans lequel l'étape de formation de la couche tampon (4) comprend une étape de dépôt d'une couche en matériau conducteur et une première étape d'oxydation de la couche en matériau conducteur.

8. Procédé de réalisation d'un empilement selon la revendication précédente, dans lequel l'étape d'élimination des excès de la couche tampon (4) et de la couche de remplissage (5) est suivie d'une deuxième étape d'oxydation d'une surface libre du reste de la couche tampon (4).

9. Procédé de réalisation d'un empilement selon l'une quelconque des revendications précédentes, dans lequel la couche de remplissage (5) est isolante.

10. Procédé de réalisation d'un empilement selon l'une quelconque des revendications 1 à 8, dans lequel la couche de remplissage (5) est apte à conduire l'électricité.

11. Procédé de réalisation d'un empilement selon l'une quelconque des revendications précédentes, dans lequel la somme de l'épaisseur la couche tampon (4) et de l'épaisseur de la couche de remplissage (5) hors volume libre (30), selon une direction d'empilement (z) de l'empilement, est supérieure ou égale à l'épaisseur nominale e de la couche d'intérêt (3) hors volume libre (30).

12. Procédé de réalisation d'un empilement selon l'une quelconque des revendications précédentes, dans lequel la couche tampon (4) est un oxyde métallique isolant.

13. Procédé de réalisation d'un empilement selon l'une quelconque des revendications précédentes, dans lequel la couche de remplissage (5) est une résine de type SU-8 ou est en parylène.

14. Procédé de réalisation d'un empilement selon l'une quelconque des revendications précédentes, dans lequel la couche tampon (4) est déposée sous vide.

15. Procédé de réalisation d'un empilement selon la revendication précédente, dans lequel la couche tampon (4) est déposée par dépôt par couche atomique.

16. Procédé de réalisation d'un empilement selon l'une quelconque des revendications précédentes, dans lequel la couche de remplissage (5) est déposée par voie liquide.

17. Procédé de réalisation d'un empilement selon l'une quelconque des revendications 2 ou 3 à 16 en ce qu'elles dépendent de la revendication 2, dans lequel l'étape d'élimination comprend les étapes suivantes :
- éliminer (113) l'excès de la couche de remplissage (5) de sorte à faire apparaître une surface libre (41) de la couche de réparation (4),
éliminer (114) l'excès de la couche tampon (4) de sorte à faire apparaître la surface libre (31) de la couche active (3).

18. Procédé de réalisation d'un empilement selon la revendication précédente, dans lequel l'étape d'élimination de l'excès de la couche tampon (4) comprend une étape d'élimination sélective permettant d'éliminer la couche tampon (4) sans attaquer la couche d'intérêt (3).

19. Procédé de réalisation d'un empilement selon l'une quelconque des revendications 17 à 18, dans lequel l'étape d'élimination de l'excès de la couche de remplissage (5) comprend une étape d'élimination sélective permettant d'éliminer la couche de remplissage (5) sans éliminer la couche tampon (4).

20. Procédé de réalisation d'un empilement selon l'une quelconque des revendications précédentes, dans lequel les volumes libres sont des défauts.

21. Empilement comprenant successivement :
- une première couche (2) apte à conduire l'électricité,
- une couche d'intérêt (3) comprenant au moins un volume libre (30),
- un élément de réparation (7) remplissant au moins partiellement un volume libre, appelé volume libre d'intérêt (30), comprenant au moins une couche en matériau isolant et laissant libre une surface supérieure (31) de la couche d'intérêt (3) située en dehors dudit au moins un volume libre,
- une deuxième couche (20) apte à conduire l'électricité recouvrant l'élément de réparation (7) et la surface supérieure (31),
l'élément de réparation (7) comprenant une couche tampon et une couche de remplissage recouvrant au moins partiellement une partie de la couche tampon située dans le volume d'intérêt (30), la couche tampon et la couche de remplissage étant réalisées dans des matériaux différents.

## Patentansprüche

1. Verfahren zur Schaffung eines Stapels (100), folgende Schritte beinhaltend:
- Bilden (101) einer ersten Schicht (2), welche in der Lage ist, Elektrizität zu leiten,
- Bilden (102) einer Schicht von Interesse (3) auf der ersten Schicht (2), wobei die Schicht von Interesse (3) mindestens ein freies Volumen beinhaltet,
- Bilden von mindestens einem Reparaturelement (7), wobei jedes Reparaturelement mindestens teilweise ein freies Volumen füllt, genannt freies Volumen von Interesse, wobei das Reparaturelement (7) mindestens eine Isolationsschicht beinhaltet und eine obere Fläche (31) der Schicht von Interesse (3) frei lässt, welche der ersten Schicht (2) gegenüber liegt und außerhalb des mindestens einen freien Volumens befindlich ist,
- Bilden (104) einer zweiten Schicht (20), welche in der Lage ist, Elektrizität zu leiten, auf der Schicht von Interesse (3), wobei die zweite Schicht (20) das Reparaturelement (7) und die freie Fläche (31) bedeckt,
wobei der Schritt des Bildens des Reparaturelements (7) folgende Schritte beinhaltet:
- Bilden (111), auf der Schicht von Interesse (3), einer Pufferschicht (4), welche sich mindestens teilweise in das freie Volumen von Interesse (30) erstreckt,
- Bedecken (112) mindestens eines Teils der in dem Volumen von Interesse (30) befindlichen Pufferschicht (4) mit einer Füllschicht (5), wobei die Pufferschicht (4) und die Füllschicht (5) aus unterschiedlichen Materialien bestehen.

2. Verfahren zur Schaffung eines Stapels nach dem vorhergehenden Anspruch, bei welchem die Füllschicht (5) in mindestens ein freies Volumen von Interesse (30) eindringt.

3. Verfahren zur Schaffung eines Stapels nach einem der vorhergehenden Ansprüche, bei welchem die Pufferschicht (4) jeden physischen Kontakt zwischen der Schicht von Interesse (3) und der Füllschicht (5) verhindert.

4. Verfahren zur Schaffung eines Stapels nach dem vorhergehenden Anspruch, zudem beinhaltend einen Schritt des Eliminierens (113, 114) eines Überschusses der Pufferschicht (4) und eines Überschusses der Füllschicht (5), um die freie Fläche (31) der Schicht von Interesse (3) bloßzulegen, und damit ein Rest der Pufferschicht (4) in dem freien Volumen von Interesse verbleibt.

5. Verfahren zur Schaffung eines Stapels nach dem vorhergehenden Anspruch, bei welchem die Füllschicht (5) in mindestens ein freies Volumen von Interesse (30) eindringt, wobei der Schritt des Eliminierens so erfolgt, dass ein Rest der Füllschicht (5) in dem freien Volumen von Interesse verbleibt, wobei der Rest mindestens teilweise den Rest der Pufferschicht (4) bedeckt.

6. Verfahren zur Schaffung eines Stapels (100) nach einem der vorhergehenden Ansprüche, bei welchem die Pufferschicht (4) eine Schicht aus Isoliermaterial ist.

7. Verfahren zur Schaffung eines Stapels nach einem der Ansprüche 1 bis 5, bei welchem der Schritt des Bildens der Pufferschicht (4) einen Schritt des Ablagerns einer Schicht aus leitfähigem Material und einen ersten Oxidationsschritt der Schicht aus leitfähigem Material beinhaltet.

8. Verfahren zur Schaffung eines Stapels nach dem vorhergehenden Anspruch, bei welchem der Schritt des Eliminierens des Überschusses der Pufferschicht (4) und der Füllschicht (5) von einem zweiten Oxidationsschritt einer freien Fläche des Restes der Pufferschicht (4) gefolgt ist.

9. Verfahren zur Schaffung eines Stapels nach einem der vorhergehenden Ansprüche, bei welchem die Füllschicht (5) isolierend ist.

10. Verfahren zur Schaffung eines Stapels nach einem der Ansprüche 1 bis 8, bei welchem die Füllschicht (5) in der Lage ist, Elektrizität zu leiten.

11. Verfahren zur Schaffung eines Stapels nach einem der vorhergehenden Ansprüche, bei welchem die Summe der Dicke der Pufferschicht (4) und der Dicke der Füllschicht (5) ohne freies Volumen (30), in einer Stapelrichtung (z) des Stapels, größer als die oder gleich der Nenndicke e der Schicht von Interesse (3) ohne freies Volumen (30) ist.

12. Verfahren zur Schaffung eines Stapels nach einem der vorhergehenden Ansprüche, bei welchem die Pufferschicht (4) ein isolierendes Metalloxid ist.

13. Verfahren zur Schaffung eines Stapels nach einem der vorhergehenden Ansprüche, bei welchem die Füllschicht (5) ein Harz vom Typ SU-8 ist oder aus Parylen besteht.

14. Verfahren zur Schaffung eines Stapels nach einem der vorhergehenden Ansprüche, bei welchem die Pufferschicht (4) unter Vakuum abgelagert wird.

15. Verfahren zur Schaffung eines Stapels nach dem vorhergehenden Anspruch, bei welchem die Pufferschicht (4) anhand von Atomlagen-Ablagerung abgelagert wird.

16. Verfahren zur Schaffung eines Stapels nach einem der vorhergehenden Ansprüche, bei welchem die Füllschicht (5) auf flüssigem Wege abgelagert wird.

17. Verfahren zur Schaffung eines Stapels nach einem der Ansprüche 2 oder 3 bis 16 in Abhängigkeit von Anspruch 2, bei welchem der Schritt des Eliminierens folgende Schritte beinhaltet:
- Eliminieren (113) des Überschusses der Füllschicht (5), um eine freie Fläche (41) der Reparaturschicht (4) bloßzulegen,
- Eliminieren (114) des Überschusses der Pufferschicht (4), um die freie Fläche (31) der aktiven Schicht (3) bloßzulegen.

18. Verfahren zur Schaffung eines Stapels nach dem vorhergehenden Anspruch, bei welchem der Schritt des Eliminierens des Überschusses der Pufferschicht (4) einen Schritt des selektiven Eiminierens beinhaltet, welcher es ermöglicht, die Pufferschicht (4) zu eliminieren, ohne die Schicht von Interesse (3) anzugreifen.

19. Verfahren zur Schaffung eines Stapels nach einem der Ansprüche 17 bis 18, bei welchem der Schritt des Eliminierens des Überschusses der Füllschicht (5) einen Schritt des selektiven Eiminierens beinhaltet, welcher es ermöglicht, die Füllschicht (5) zu eliminieren, ohne die Pufferschicht (4) zu eliminieren.

20. Verfahren zur Schaffung eines Stapels nach einem der vorhergehenden Ansprüche, bei welchem die freien Volumina Fehler sind.

21. Stapel, nacheinander Folgendes beinhaltend:
- eine erste Schicht (2), welche in der Lage ist, Elektrizität zu leiten,
- eine Schicht von Interesse (3), welche mindestens ein freies Volumen (30) beinhaltet,
- ein Reparaturelement (7), welches mindestens teilweise ein freies Volumen füllt, genannt freies Volumen von Interesse (30), welches mindestens eine Schicht aus Isolationsmaterial beinhaltet und eine obere Fläche (31) der Schicht von Interesse (3) frei lässt, welche außerhalb des mindestens einen freien Volumens befindlich ist,
- eine zweite Schicht (20), welche in der Lage ist, Elektrizität zu leiten und das Reparaturelement (7) und die obere Fläche (31) bedeckt,
wobei das Reparaturelement (7) eine Pufferschicht und eine Füllschicht beinhaltet, welche mindestens teilweise einen Teil der in dem Volumen von Interesse (30) befindlichen Pufferschicht bedeckt, wobei die Pufferschicht und die Füllschicht aus unterschiedlichen Materialien bestehen.

## Claims

1. A method for producing a stack (100), comprising the following steps:
- forming (101) a first layer (2) able to conduct electricity,
- forming (102) a layer of interest (3) on the first layer (2), said layer of interest (3) comprising at least one free volume,
- forming at least one repairing element (7), each repairing element at least partially filling a free volume, called the free volume of interest, the repairing element (7) comprising at least one insulating layer and leaving free an upper surface (31) of the layer of interest (3) opposite the first layer (2) and located outside of said at least one free volume,
- forming (104) a second layer (20), able to conduct electricity, on the layer of interest (3), the second layer (20) covering the repairing element (7) and the free surface (31),
the step of forming the repairing element (7) comprising the following steps:
- forming (111), on the layer of interest (3), a buffer layer (4) that extends at least partially into the free volume of interest (30),
- covering (112) at least one portion of the buffer layer (4) located in the volume of interest (30) with a filling layer (5), said buffer layer (4) and the filling layer (5) being made from different materials.

2. The method for producing a stack as claimed in the preceding claim, wherein the filling layer (5) penetrates into at least one free volume of interest (30).

3. The method for producing a stack according either one of the preceding claims, wherein the buffer layer (4) prevents any physical contact between the layer of interest (3) and the filling layer (5).

4. The method for producing a stack according to the preceding claim, furthermore comprising a step of removing (113, 114) an excess of the buffer layer (4) and an excess of the filling layer (5) so as to make the free surface (31) of the layer of interest (3) appear and so as to leave a remainder of the buffer layer (4) in the free volume of interest.

5. The process for producing a stack according to the preceding claim, wherein the filling layer (5) penetrates into at least one free volume of interest (30) and the removal step is carried out so as to leave a remainder of the filling layer (5) in said free volume of interest, said remainder at least partially covering the remainder of the buffer layer (4).

6. The process for producing a stack (100) according to any one of the preceding claims, wherein the buffer layer (4) is a layer made of insulating material.

7. The process for producing a stack according to any one of claims 1 to 5, wherein the step of forming the buffer layer (4) comprises a step of depositing a layer made of conductive material and a first step of oxidizing the layer made of conductive material.

8. The process for producing a stack according to the preceding claim, wherein the step of removing the excess of the buffer layer (4) and of the filling layer (5) is followed by a second step of oxidizing a free surface of the remainder of the buffer layer (4).

9. The process for producing a stack according to any one of the preceding claims, wherein the filling layer (5) is insulating.

10. The process for producing a stack according to any one of claims 1 to 8, wherein the filling layer (5) is able to conduct electricity.

11. The process for producing a stack as claimed in any one of the preceding claims, wherein the sum of the thickness of the buffer layer (4) and of the thickness of the filling layer (5) outside of the free volume (30), in a stacking direction (z) of the stack, is larger than or equal to the nominal thickness e of the layer of interest (3) outside of the free volume (30).

12. The process for producing a stack according to any one of the preceding claims, wherein the buffer layer (4) is an insulating metal oxide.

13. The process for producing a stack according to any one of the preceding claims, wherein the filling layer (5) is a resist of SU-8 type or is made of parylene.

14. The process for producing a stack according to any one of the preceding claims, wherein the buffer layer (4) is vacuum deposited.

15. The process for producing a stack according to the preceding claim, wherein the buffer layer (4) is deposited by atomic layer deposition.

16. The process for producing a stack according to any one of the preceding claims, wherein the filling layer (5) is deposited by wet processing.

17. The process for producing a stack according to any one of claims 2 or 3 to 16 when they depend on claim 2, wherein the removal step comprises the following steps:
- removing (113) the excess the filling layer (5) so as to make a free surface (41) of the repairing layer (4) appear,
- removing (114) the excess of the buffer layer (4) so as to make the free surface (31) of the active layer (3) appear.

18. The process for producing a stack according to the preceding claim, wherein the step of removing the excess of the buffer layer (4) comprises a selective removal step allowing the buffer layer (4) to be removed without attacking the layer of interest (3).

19. The process for producing a stack according to either one of claims 17 to 18, wherein the step of removing the excess of the filling layer (5) comprises a selective removal step allowing the filling layer (5) to be removed without removing the buffer layer (4).

20. The process for producing a stack according to any one of the preceding claims, wherein the free volumes are defects.

21. A stack comprising, in succession:
- a first layer (2) able to conduct electricity,
- a layer of interest (3) comprising at least one free volume (30),
- a repairing element (7) at least partially filling a free volume, called the free volume of interest (30), comprising at least one layer made of insulating material and leaving free an upper surface (31) of the layer of interest (3) located outside of said at least one free volume,
- a second layer (20), able to conduct electricity covering the repairing element (7) and the upper surface (31),
the repairing element (7) comprising a buffer layer and a filling layer at least partially covering a portion of the buffer layer located in the volume of interest (30), the buffer layer and the filling layer being made from different materials.
